# FASCICULE DE BREVET EUROPEEN

(11) **EP 0 917 992 B1**
(45) Date de publication et mention de la délivrance du brevet: **10.09.2003**
(21) Numéro de dépôt: 98402914.0
(22) Date de dépôt: 24.11.1998
(51) Int. Cl.: B60R 16/02

(54) **Module de gestion pour habitacle de véhicule automobile, procédé pour sa réalisation et boîtier de module de gestion correspondant**
Steuermodul für den Kraftfahrzeug-Innenraum, Verfahren zu seiner Herstellung und entsprechendes Steuergerätegehäuse
Vehicle passenger compartment control module, method of realising such a module and corresponding control module housing

(30) Priorité: 24.11.1997 FR 9714714
(43) Date de publication de la demande: 26.05.1999
(73) Titulaire: VALEO ELECTRONIQUE, 94000 Creteil (FR)
(72) Inventeur: Boucheron, Jean-Louis, 77176 Savigny le Temple (FR); Fargues, Emmanuel, 75012 Paris (FR)
(74) Mandataire: Texier, Christian

(56) Documents cités:
- EP-A- 0 567 403
- EP-A- 0 739 783
- WO-A-91/07865
- DE-A- 4 028 504
- DE-A- 4 037 603
- FR-A- 2 669 179
- FR-A- 2 746 736
- "ELECTRONIC HIGH-DENSITY PACKAGING FOR UNDER THE HOOD" AUTOMOTIVE ENGINEERING, vol. 100, no. 3, 1 mars 1992, pages 13-15, XP000265650

## Description

La présente invention concerne les modules de gestion pour les habitacles de véhicules automobiles, un procédé pour la réalisation d'un tel module et un boîtier de module de gestion.

Plus particulièrement, elle concerne les modules de gestion qui associent d'une part une carte électronique pour la gestion de différentes fonctions sur le véhicule et d'autre part une carte de puissance destinée à assurer la protection des circuits commandés, ainsi que le relayage et la distribution de la puissance.

Un module selon les caractéristiques du préambule de la revendication 1 est divulgué par WO 91/07865 A1.

La principale difficulté technologique rencontrée avec les modules de gestion de ce type réside dans le couplage mécanique et électronique entre la carte de puissance et la carte de gestion.

La carte de puissance est en effet un circuit imprimé destiné à protéger des circuits commutant des courants allant jusqu'à 40 ampères ou supérieurs. Elle intègre des dispositifs de protection, tels que des fusibles et des relais, et doit présenter des épaisseurs de substrat et de couches de cuivre importantes. L'épaisseur globale de la couche de cuivre est généralement de l'ordre de 200 à 400 microns.

La carte de gestion, qui intègre l'électronique de commande, ne nécessite quant à elle qu'un substrat de faible épaisseur. Elle consiste par exemple en un circuit imprimé simple ou double faces avec une ou deux couches de cuivre de l'ordre de 35 µm d'épaisseur.

La carte de puissance et la carte de gestion correspondent donc à des technologies de réalisation et de connexion différentes.

De ce fait, le raccordement entre les deux cartes, carte de puissance et carte de gestion, est difficile.

Cette difficulté est en outre accrue par le fait que la carte de puissance nécessite des pistes de largeur importante et qu'il n'est pas possible de regrouper les points de connexion en un seul lieu, car le routage de la carte de puissance s'avérerait impossible à réaliser.

Le but du présent brevet est de répondre au problème posé par la connexion entre les deux parties par une solution simple, peu coûteuse et adaptée.

On connaît par DE 40 37 603 ou encore par l'article « Electronic high density packaging for under the hood » - Automotive engineering - vol.100, n°3, 1^{er} mars 1992, pages 13-15, des modules de commande qui comportent une carte de puissance et une carte de gestion dans un même boîtier.

Mais les modules de commande décrits dans ces deux documents ne permettent pas l'insertion de composants de puissance autrement qu'en ouvrant leurs boîtiers.

Leurs boîtiers sont constitués de plusieurs pièces distinctes et nécessitent par conséquent plusieurs moules de fabrication.

En outre, on notera que les structures décrites dans DE 40 37 603 dans lesquelles une carte électronique est disposée perpendiculairement à une carte de puissance sont d'un encombrement important et n'offrent pas une protection mécanique satisfaisante de la carte électronique.

L'invention propose quant à elle un module de gestion pour habitacle de véhicule automobile, comportant un boîtier, ainsi qu'au moins une carte de puissance et au moins une carte de gestion disposées dans ledit boîtier, caractérisé en ce que ledit boîtier est constitué de deux demi-boîtiers refermés l'un sur l'autre et articulés autour d'une charnière avec laquelle ils sont d'une pièce, l'un des demi-boîtiers comportant des moyens formant logement qui reçoivent des languettes et/ou des broches femelles qui définissent des connecteurs avec lesdits moyens formant logement, ainsi qu'une enveloppe qui assure la protection mécanique de la carte de gestion, et en ce que la carte de gestion s'étend sensiblement perpendiculairement par rapport à la carte de puissance que lesdits demi-boitiers soient refermés l'un sur l'autre ou non.

Ledit module est avantageusement complété par les différentes caractéristiques suivantes prises seules ou selon toutes leurs combinaisons techniquement possibles :
- la carte de gestion présente une pluralité de pistes qui se prolongent au-delà de ladite carte, lesdites pistes étant portées sur ladite carte par des zones séparées par des encoches et la carte de puissance porte une pluralité de fentes dans lesquelles lesdites zones qui portent lesdites pistes sont destinées à s'étendre, ladite carte de puissance portant elle-même au niveau desdites fentes des pistes avec lesquelles les pistes de la carte de gestion sont raccordées ;
- la carte de puissance comporte plusieurs circuits imprimés simple face superposés ;
- la carte de puissance comporte un ou plusieurs circuits imprimés flexibles ;
- le demi-boîtier qui comporte des moyens formant logement qui reçoivent des languettes et/ou des broches femelles, ainsi qu'une enveloppe qui assure la protection mécanique de la carte de gestion, porte également au moins un logement pour un composant directement soudé sur la carte de puissance.

L'invention concerne également un procédé pour la réalisation d'un tel module, caractérisé par les différentes étapes suivantes :
- on introduit la carte de gestion, les languettes et broches femelles dans les logements qui leur correspondent sur l'un des demi-boîtiers ;
- on met ensuite en place la carte de puissance sur les extrémités desdites languettes et broches, ainsi que sur la carte de gestion ;
- on positionne sur ledit demi-boîtier et la carte de puissance le ou les éventuel(s) composants de puissance ;
- on réalise ensuite, sur la face de la plaque où débouchent les extrémités des languettes, des broches et du ou des éventuel(s) composants de puissance du type du relais, une soudure à la vague ;
- on referme les deux demi-boîtiers l'un sur l'autre.

L'invention concerne en outre un boîtier de module de gestion du type précité, caractérisé en ce qu'il est constitué de deux demi-boîtiers refermés l'un sur l'autre et articulés autour d'une charnière avec laquelle ils sont d'une pièce, l'un des demi-boîtiers comportant des moyens formant logement destinés à recevoir des languettes et/ou des broches femelles qui définissent des connecteurs avec lesdits moyens formant logement, ainsi qu'une enveloppe destinée à assurer la protection mécanique de la carte de gestion.

La description qui suit est purement illustrative et non limitative. Elle doit être lue en regard des dessins annexés sur lesquels :
- la figure 1 est une représentation en vue en coupe d'un module conforme à un mode de réalisation de l'invention ;
- la figure 2 est une représentation en vue en coupe du boîtier du module de la figure 1 ;
- les figures 3 à 7 illustrent différentes étapes de montage du module de la figure 1 ;
- la figure 8 une vue en coupe illustrant une variante de réalisation possible pour la carte de puissance du module de la figure 1 ;
- la figure 9 est une représentation schématique illustrant un mode de réalisation de la liaison entre la carte de gestion et la carte de puissance.

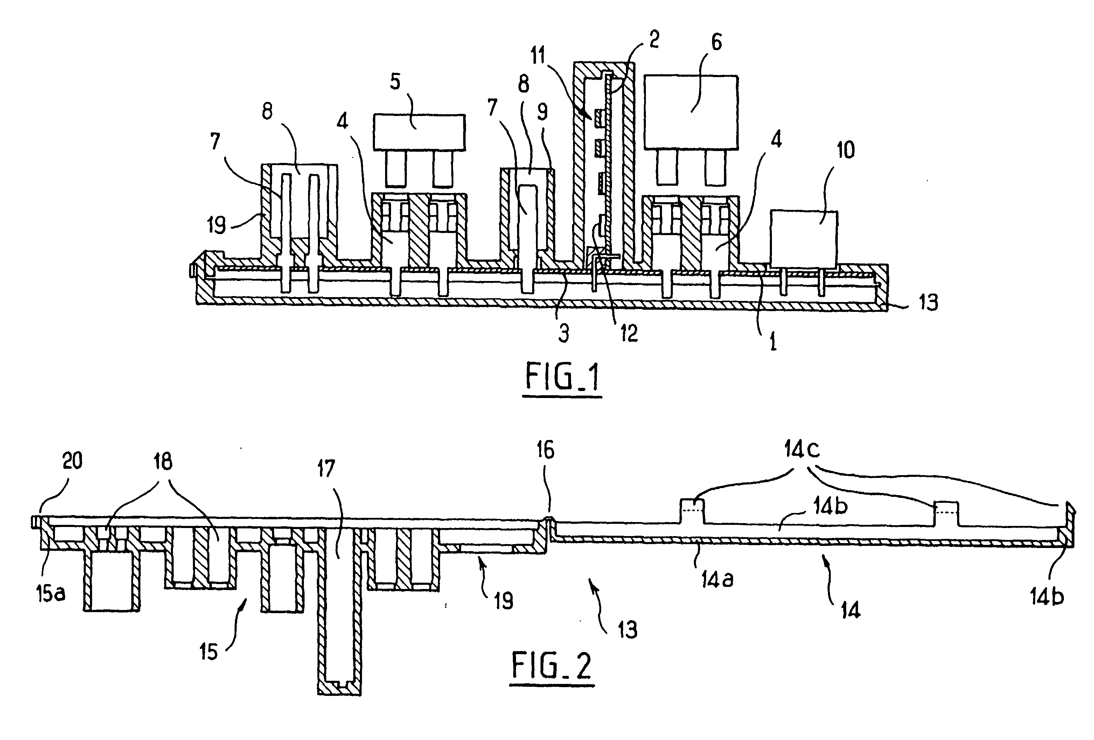

Le module de gestion représenté sur la figure 1 peut être un module de calculateur d'habitacle et comporte une carte de puissance 1, une carte de gestion 2.

La carte de puissance 1 comporte un circuit imprimé 3 sur lequel sont montés des éléments traversants tels que :
- des broches femelles 4 sur lesquelles sont destinés à être embrochés des fusibles 5 et des relais 6,
- des languettes de connexion 7, qui définissent, avec des jupes de guidage 18 à l'intérieur desquelles elles sont disposées, des connecteurs 8 permettant notamment le raccordement à des bornes d'alimentation à la tension de la batterie ou aux différents organes commandés,
- un ou plusieurs composants de puissance (relais 10) soudés sur ledit circuit imprimé 3.

Le circuit imprimé 3 est par exemple un circuit imprimé simple face, seule la face où débouchent les extrémités desdits éléments traversants 4, 7 et 10 étant cuivrée.

Ledit circuit 3 est par exemple un circuit découpé surmoulé ou un circuit imprimé d'épaisseur de cuivre de forte épaisseur (par exemple 105 à 400 microns) ou encore un circuit flexible de cuivre de forte épaisseur. Il peut présenter une ou plusieurs couches.

D'autres types de composants que ceux indiqués ci-dessus peuvent bien entendu être envisagés (diodes ou autres composants de puissance, par exemple).

La carte électronique 2 est constituée par un circuit imprimé à substrat epoxy qui porte une pluralité de composants électroniques 11. Sur l'exemple illustré sur la figure 1, ledit circuit imprimé est de type double face, mais il peut bien entendu être de type simple face. Les couches de cuivre utilisées sont d'une épaisseur de 35 microns.

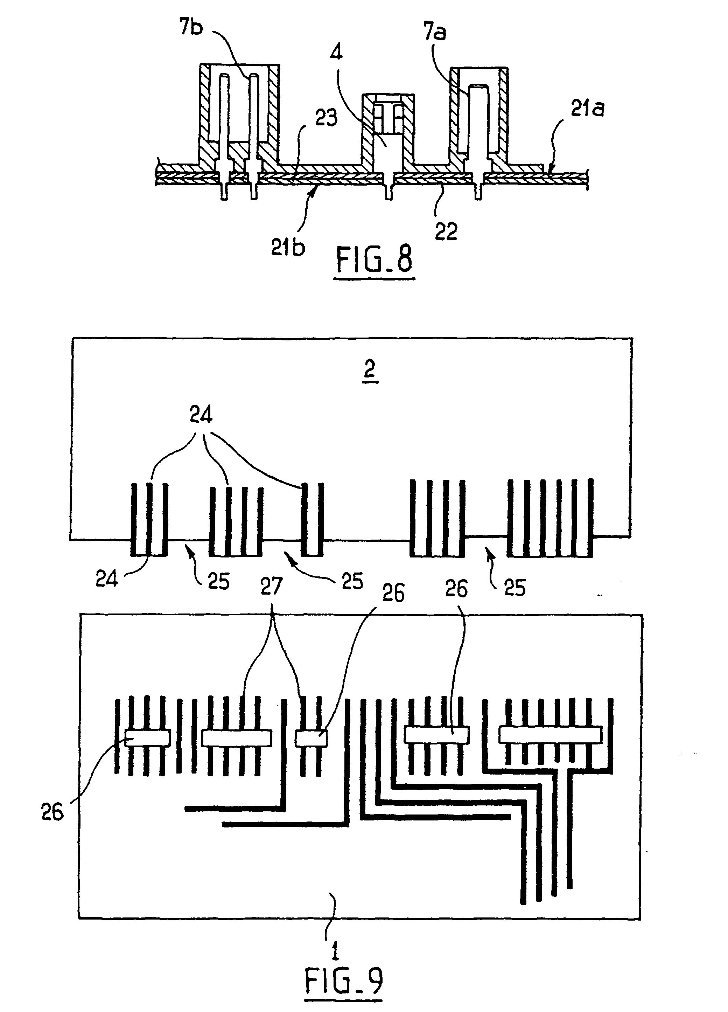

La carte électronique 2 s'étend perpendiculairement au plan de la carte de puissance 1 et est reliée au circuit imprimé 3 de ladite carte 1 par un connecteur à souder 12, qui est par exemple constitué par des fils rigides ou encore, ainsi qu'on l'a illustré sur la figure 1, par des barrettes coudées. D'autres variantes de moyens de connexion particulièrement avantageux sont décrits plus loin en référence à la figure 9.

La carte de puissance 1 est reçue avec la carte électronique 2 dans un boîtier monobloc 13 en matière plastique qui est conformé de façon d'une part à envelopper lesdites cartes 1 et 2 pour les protéger contre les chocs ou contraintes mécaniques et d'autre part à définir des logements 18 qui définissent avec les broches 4 et les languettes 7, les connecteurs du module.

Ce boîtier 13 est plus particulièrement représenté sur la figure 2. Il est constitué d'un premier demi-boîtier 14 (demi-boîtier inférieur sur la figure 1) et d'un deuxième demi-boîtier 15 (demi-boîtier supérieur sur la figure 1), qui sont articulés l'un sur l'autre par une charnière 16 venue de moulage avec lesdits demi-boîtiers 14 et 15.

Le demi-boîtier inférieur 14 présente un fond plat 14a, bordé par des parois 14b et se prolongeant par des pattes de fixation élastiques 14c portant des protubérances formant crochet.

Le demi-boîtier supérieur 15 comporte un renfoncement borgne 17 qui définit l'enveloppe de protection de la carte électronique 2 de gestion.

Il comporte également des logements (jupes 18) bordés par des parois qui sont destinées à coopérer avec les languettes 7 et les broches 4 pour définir les connecteurs du module.

Il comporte en outre des évidements 19 destinés à recevoir des composants directement soudés sur le circuit imprimé 3.

Ce demi-boîtier 15 est par ailleurs bordé par une paroi 15a dont la tranche est destinée à venir en contact avec la tranche de la paroi 14b. Cette paroi 15a présente en outre des alvéoles 20 qui sont destinées à coopérer avec les crochets des pattes de fixation 14c, pour maintenir lesdits demi-boîtiers 14 et 15 l'un par rapport à l'autre.

Le boîtier 13 peut également avantageusement des protubérances extérieures (non représentées) conformées pour permettre sa fixation sur un véhicule, par exemple des pattes ou oreilles de fixation.

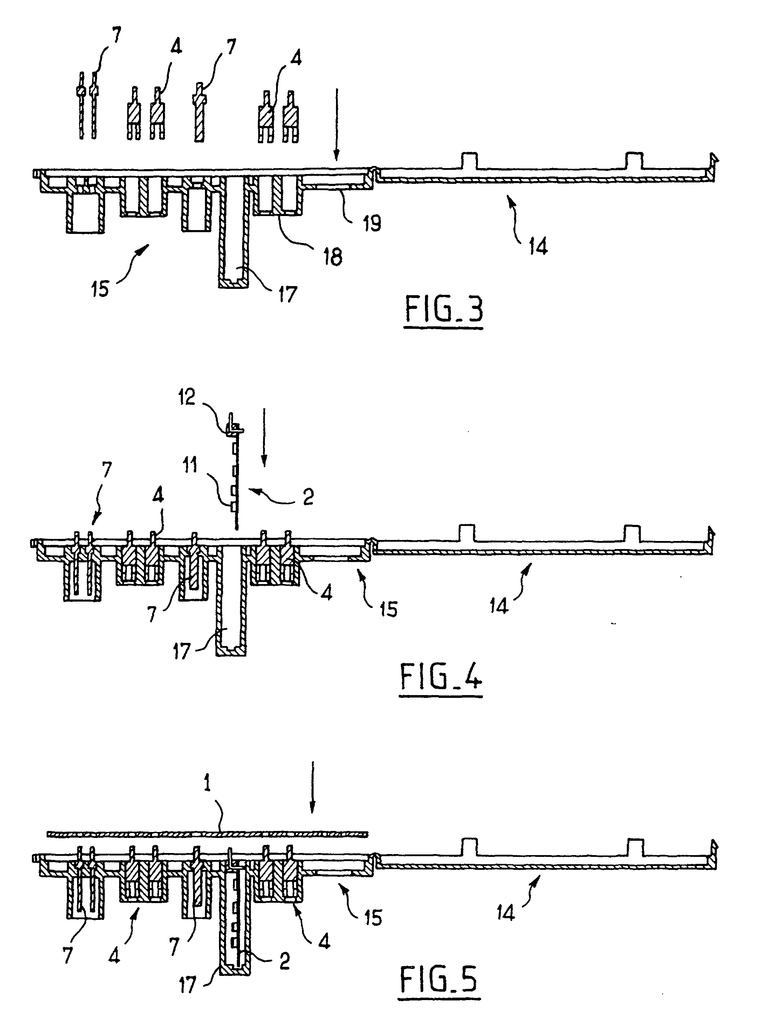

Les figures 3 à 7 illustrent les différentes étapes du montage du module de la figure 1.

Le boîtier 13 étant initialement ouvert, on introduit les languettes 7 et broches 4 dans leurs logements 18 respectifs (figure 3).

Puis, on introduit la carte électronique 2 dans son logement 17 (figure 4).

On met ensuite en place la carte 1 du circuit de puissance sur les extrémités desdites languettes 7 et broches 4 (figure 5).

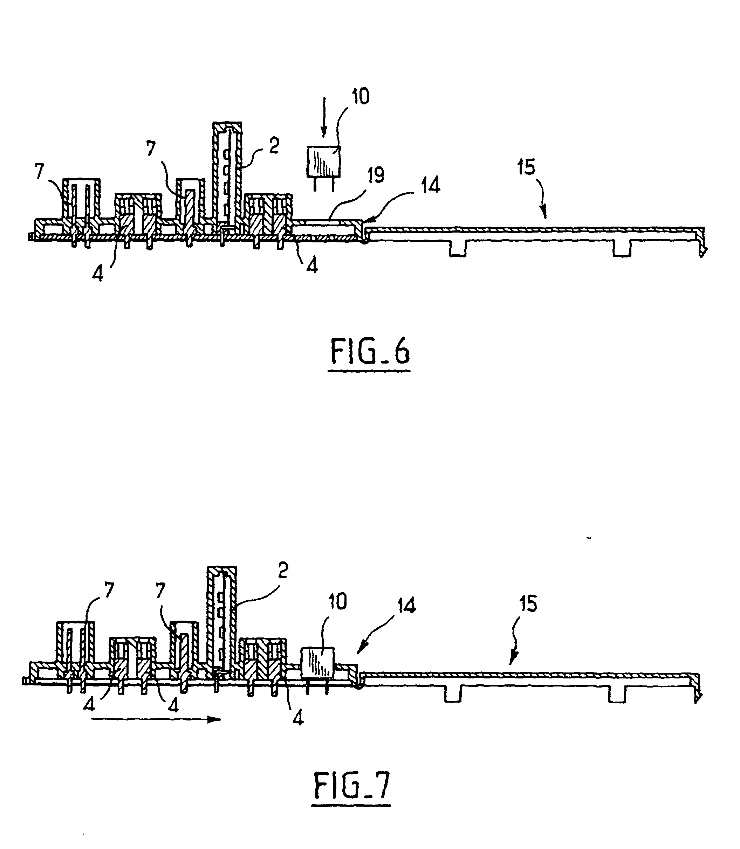

Une fois la plaque 1 positionnée sur les languettes 7 et broches 4, on retourne le demi-boîtier 15a , puis on positionne sur celui-ci les composants de puissance, qui, comme le relais 10, sont destinés à être directement soudés sur ladite plaque (figure 6).

On réalise ensuite, sur la face de la plaque 1 où débouchent les extrémités des languettes 7, des broches 4 et des composants de puissance du type du relais 10, une soudure à la vague qui permet de réunir toutes les équipotentielles nécessaires à l'obtention du schéma désiré (soudure selon le sens de la flèche de la figure 7).

Les demi-boîtiers 15a et 14b sont ensuite refermés l'un sur l'autre.

Dans l'exemple de réalisation qui vient d'être décrit en référence aux figures 3 à 7, on a supposé que le circuit imprimé 3 de la carte de puissance 1 était de type rigide. En variante, il est bien entendu possible d'utiliser un circuit 3 de type flexible que l'on applique le long d'une surface plane intérieure du boîtier 13, telle que par exemple la surface intérieure du demi-boîtier 14.

La fixation du circuit flexible sur cette surface peut être assurée par collage ou par sertissage à chaud de pions venant du boîtier lui-même et passant au travers des trous du circuit flexible.

La soudure illustrée sur la figure 7 permet d'assurer la liaison entre deux composants. Une soudure avec une seule couche de cuivre peut toutefois s'avérer insuffisante pour réaliser l'ensemble du schéma requis. Dans ce cas, on pourra avoir recours à un circuit de puissance double face, ou un empilage de circuits simple face.

Un montage dans laquelle carte 1 est constituée par deux circuits simple face 21a, 21b empilés est illustré sur la figure 8. Dans ce montage, une première languette 7a est connectée au premier circuit 21a et reliée à une broche 4 par une couche cuivre 22 dudit premier circuit 21a. Cette broche 4 est reliée à une languette 7b par une couche cuivre 23 déposée sur le second circuit 21b.

Avec un tel montage utilisant plusieurs circuits empilés, il est possible de souder un même élément sur deux voir plusieurs circuits superposés, ce qui permet de disposer de liaisons croisées et d'augmenter la complexité des circuits réalisés.

Les queues des languettes ou broches sont à cet effet préférentiellement étagées sur plusieurs niveaux, correspondant aux différentes couches de circuits.

La figure 9 illustre un mode de réalisation de la liaison entre la carte électronique 2 et la carte de puissance 1 dans laquelle on utilise, pour assurer la liaison entre lesdites cartes, une pluralité de pistes 24 situées sur la carte électronique et se prolongeant au-delà de ladite carte 2 pour constituer des pistes traversantes la carte de puissance 1. A cet effet, des encoches 25 sont découpées sur la carte 2 entre les zones où s'étendent les pistes 24 et la carte 1 présente une pluralité de fentes 26 destinées à recevoir les parties entre lesdites encoches 25 qui portent lesdites pistes 24 et dépassent de la carte 2.

La carte 1 porte elle-même, de part et d'autre desdites fentes 26, des pistes 27 qui se trouvent dans le prolongement desdites pistes 24 lorsque la carte 2 est en place sur la carte 1, et avec lesquelles lesdites pistes 24 sont raccordées.

Ainsi, une telle disposition permet de raccorder la carte électronique au substrat de puissance en ménageant des possibilités de routage de la carte de puissance, sans utiliser de connecteur ou de bout de raccordement.

## Revendications

1. Module de gestion pour habitacle de véhicule automobile, comportant un boîtier, ainsi qu'au moins une carte de puissance (1) et au moins une carte de gestion (2) disposées dans ledit boîtier, **caractérisé en ce que** ledit boîtier (13) est constitué de deux demi-boîtiers (14, 15) refermés l'un sur l'autre et articulés autour d'une charnière (16) avec laquelle ils sont d'une pièce, l'un (15) des demi-boîtiers comportant des moyens (18) formant logement qui reçoivent des languettes et/ou des broches femelles qui définissent des connecteurs avec lesdits moyens formant logement, ainsi qu'une enveloppe (17) qui assure la protection mécanique de la carte de gestion (2), et **en ce que** la carte de gestion s'étend sensiblement perpendiculairement par rapport à la carte de puissance (1) que lesdits demi-boîtiers (14,15) soient refermés l'un sur l'autre ou non.

2. Module selon la revendication 1, **caractérisé en ce que** la carte de gestion (2) présente une pluralité de pistes (24) qui se prolongent au-delà de ladite carte, lesdites pistes (24) étant portées sur ladite carte (2) par des zones séparées par des encoches (25) et **en ce que** la carte de puissance (1) porte une pluralité de fentes (26) dans lesquelles lesdites zones qui portent lesdites pistes (24) sont destinées à s'étendre, ladite carte de puissance (1) portant elle-même au niveau desdites fentes des pistes (27) avec lesquelles les pistes (24) de la carte de gestion (2) sont raccordées.

3. Module selon l'une des revendications précédentes, **caractérisé en ce que** la carte de puissance (1) comporte plusieurs circuits imprimés simple face superposés (21a, 21b).

4. Module selon l'une des revendications 1 et 2, **caractérisé en ce que** la carte de puissance (1) comporte un circuit imprimé flexible.

5. Module selon l'une des revendications précédentes, **caractérisé en ce que** le demi-boîtier (15) qui comporte des moyens (18) formant logement qui reçoivent des languettes et/ou des broches femelles, ainsi qu'une enveloppe (17) qui assure la protection mécanique de la carte de gestion, porte également au moins un logement (19) pour un composant directement soudé sur la carte de puissance (**1**).

6. Procédé pour la réalisation d'un module selon l'une des revendications précédentes, **caractérisé par** les différentes étapes suivantes :
- on introduit la carte de gestion, les languettes et broches femelles (4, 7) dans les logements (18) qui leur correspondent sur l'un des demi-boîtiers (15) ;
- on met ensuite en place la carte de puissance (1) sur les extrémités desdites languettes et broches (4, 7), ainsi que sur la carte de gestion (2)
- on positionne sur ledit demi-boîtier et la carte de puissance (1) le ou les éventuel(s) composants de puissance (10) ;
- on réalise ensuite, sur la face de la plaque où débouchent les extrémités des languettes, des broches (4, 7) et du ou des éventuel(s) composants de puissance (10) du type du relais, une soudure à la vague ;
- on referme les deux demi-boîtiers (14, 15) l'un sur l'autre.

7. Boîtier de module de gestion selon l'une des revendications 1 à 5, **caractérisé en ce qu'**il est constitué de deux demi-boîtiers (14, 15) refermés l'un sur l'autre et articulés autour d'une charnière (16) avec laquelle ils sont d'une pièce, l'un (15) des demi-boîtiers comportant des moyens formant logement destinés à recevoir des languettes et/ou des broches femelles (4, 7) qui définissent des connecteurs avec lesdits moyens formant logement, ainsi qu'une enveloppe (17) destinée à assurer la protection mécanique de la carte de gestion.

## Patentansprüche

1. Steuermodul für den Innenraum eines Kraftfahrzeugs mit einem Gehäuse sowie mit wenigstens einer Leistungskarte (1) und wenigstens einer Steuerungskarte (2), die in dem besagten Gehäuse angeordnet sind, **dadurch gekennzeichnet, daß** das besagte Gehäuse (13) aus zwei Gehäusehälften (14, 15) besteht, die aneinander verschlossen und um ein Gelenkband (16) angelenkt sind, mit dem sie einstückig ausgeführt sind, wobei eine (15) der Gehäusehälften als Aufnahme dienende Mittel (18), die Zungen und/oder Steckbuchsen aufnehmen, die zusammen mit den besagten als Aufnahme dienenden Mitteln Verbinder definieren, sowie eine. Umhüllung (17) umfaßt, die den mechanischen Schutz der Steuerungskarte (2) sicherstellt, und **daß** sich die Steuerungskarte in etwa senkrecht im Verhältnis zur Leistungskarte (1) erstreckt, unabhängig davon, ob die besagten Gehäusehälften (14, 15) aneinander verschlossen sind oder nicht.

2. Modul nach Anspruch 1, **dadurch gekennzeichnet, daß** die Steuerungskarte (2) eine Mehrzahl von Leiterbahnen (24) aufweist, die über die besagte Karte hinaus verlängert sind, wobei die besagten Leiterbahnen (24) auf der besagten Karte (2) durch Bereiche angebracht sind, die durch Ausnehmungen (25) getrennt sind, und **daß** die Leistungskarte (1) eine Mehrzahl von Schlitzen (26) enthält, in denen sich die besagten Bereiche, welche die besagten Leiterbahnen (24) tragen, erstrecken sollen, wobei die besagte Leistungskarte (1) ihrerseits in Höhe der besagten Schlitze Leiterbahnen (27) trägt, mit denen die Leiterbahnen (24) der Steuerungskarte (2) verbunden sind.

3. Modul nach einem der vorangehenden Ansprüche, **dadurch gekennzeichnet, daß** die Leistungskarte (1) mehrere übereinander angeordnete einseitige gedruckte Schaltungen (21a, 21b) umfaßt.

4. Modul nach einem der Ansprüche 1 und 2, **dadurch gekennzeichnet, daß** die Leistungskarte (1) eine biegsame gedruckte Schaltung umfaßt.

5. Modul nach einem der vorangehenden Ansprüche, **dadurch gekennzeichnet, daß** die Gehäusehälfte, die als Aufnahme dienende Mittel (18), die Zungen und/oder Steckbuchsen aufnehmen, sowie eine Umhüllung (17) umfaßt, die den mechanischen Schutz der Steuerungskarte sicherstellt, außerdem wenigstens eine Aufnahme (19) für ein direkt an der Leistungskarte (1) angelötetes Bauelement trägt.

6. Verfahren zur Herstellung eines Moduls nach einem der vorangehenden Ansprüche, **gekennzeichnet durch** die folgenden verschiedenen Schritte:
- die Steuerungskarte, die Zungen und die Steckbuchsen (4, 7) werden in die ihnen entsprechenden Aufnahmen (18) an einer der Gehäusehälften (15) eingesetzt;
- anschließend wird die Leistungskarte (1) an den Enden der besagten Zungen und Steckbuchsen (4, 7) sowie an der Steuerungskarte (2) angebracht;
- an der besagten Gehäusehälfte und an der Leistungskarte (1) wird/werden die eventuelle(n) Leistungskomponente(n) (10) positioniert;
- daraufhin wird auf der Seite der Platte, an der die Enden der Zungen, der Steckbuchsen (4, 7) und der eventuellen Leistungskomponente(n) (10) vom Relaistyp münden, eine Wellenlötung ausgeführt;
- die beiden Gehäusehälften (14, 15) werden aneinander verschlossen.

7. Gehäuse für ein Steuermodul nach einem der Ansprüche 1 bis 5, **dadurch gekennzeichnet, daß** es aus zwei Gehäusehälften (14, 15) besteht, die aneinander verschlossen und um ein Gelenkband (16) angelenkt sind, mit dem sie einstückig ausgeführt sind, wobei eine (15) der Gehäusehälften als Aufnahme dienende Mittel, die dazu bestimmt sind, Zungen und/oder Steckbuchsen (4,7) aufzunehmen, die zusammen mit den besagten als Aufnahme dienenden Mitteln Verbinder definieren, sowie eine Umhüllung (17) umfaßt, die den mechanischen Schutz der Steuerungskarte sicherstellt.

## Claims

1. A control module for a motor vehicle cab, the module comprising a box, at least one power card (1) and at least one control card (2) placed in said box, the module being **characterized in that** said box (13) is constituted by two half-boxes (14, 15) that are closed together and hinged about a hinge (16) with which they are integrally formed, one of the half-boxes (15) having means (18) forming housings that receive tongues and/or female pins which co-operate with said housing-forming means to define connectors, and also having a case (17) which provides mechanical protection for the control card (2), and **in that** the control card extends substantially perpendicularly to the power card (1) whether or not said half-boxes (14, 15) are closed together.

2. A module according to claim 1, **characterized in that** the control card (2) has a plurality of tracks (24) which extend beyond said card, said tracks (24) being carried on said card (2) by zones that are separated by notches (25), and **in that** the power card (1) has a plurality of slots (26) in which said zones carrying said tracks (24) are designed to extend, said power card (1) itself having tracks (27) at said slots to which the tracks (24) of the control card (2) are connected.

3. A module according to either preceding claim, **characterized in that** the power card (1) comprises a plurality of superposed single-sided printed circuits (21a, 21b).

4. A module according to claim 1 or 2, **characterized in that** the power card (1) comprises a flexible printed circuit.

5. A module according to any preceding claim, **characterized in that** the half-box (15) which includes housing-forming means (18) which receive tongues and/or female pins, and also a case (17) which provides mechanical protection for the control card, also carries at least one housing (19) for a component that is soldered directly to the power card (1).

6. A method of making a module according to any preceding claim, the method being **characterized by** the various following steps:
the control card, the tongues, and the female pins (4, 7) are inserted in the housings (18) corresponding thereto in one of the half-boxes (15);
· thereafter, the power card (1) is put in place on the ends of said tongues and pins (4, 7) and on the control card (2);
· any optional power components (10) are positioned on said half-box and the power card (1);
· flow soldering is then performed on the face of the card through which there project the ends of the tongues, the pins (4, 7), and any power components (10) of the relay type; and
· the two half-boxes (14, 15) are closed together.

7. A box for a control module according to any one of claims 1 to 5, the box being **characterized in that** it is constituted by two half-boxes (14, 15) that are closed together and hinged about a hinge (16) integrally formed therewith, one of the half-boxes (15) including housing-forming means for receiving tongues and/or female pins (4, 7) which co-operate with said housing-forming means to define connectors, and also a case (17) for providing mechanical protection to the control card.
